(19) Europäisches Patentamt
European Patent Office
Office européen des brevets

(11) Numéro de publication : **0 320 344 B1**

(12) # FASCICULE DE BREVET EUROPEEN

(45) Date de publication du fascicule du brevet : **15.04.92 Bulletin 92/16**

(51) Int. Cl.[5] : **C08F 214/22,** C08F 259/08, H01L 41/18, // (C08F259/08, 214:22)

(21) Numéro de dépôt : **88403040.4**

(22) Date de dépôt : **01.12.88**

(54) **Copolymères piézoélectriques de fluorure de vinylidène et de trifluoroéthylène.**

(30) Priorité : **08.12.87 FR 8717084**

(43) Date de publication de la demande : **14.06.89 Bulletin 89/24**

(45) Mention de la délivrance du brevet : **15.04.92 Bulletin 92/16**

(84) Etats contractants désignés : **AT BE CH DE FR GB IT LI NL SE**

(56) Documents cités :
**FR-A- 2 333 817**
**GB-A- 2 184 737**

(73) Titulaire : **ATOCHEM**
**4 & 8, Cours Michelet La Défense 10**
**F-92800 Puteaux (FR)**

(72) Inventeur : **Kappler, Patrick**
**20, Allée Simon St Jean**
**F-69130 Ecully (FR)**

(74) Mandataire : **Foiret, Claude et al**
**ATOCHEM, Département Propriété Industrielle, La Défense 10, Cédex 42**
**F-92091 Paris La Défense (FR)**

EP 0 320 344 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un copolymère hétérogène de fluorure de vinylidène ($VF_2$)et de trifluoroéthylène ($C_2F_3H$) possédant à la fois des propriétés piézoélectriques et une température maximum d'utilisation élevées.

Les propriétés piézoélectriques de films ou de plaques sont définies par des coefficients de proportionnalité entre les effets mécaniques et les effets électriques. Ces coefficients sont obtenus en mesurant la densité de charges qui apparait sur les faces du film ou de la plaque quand on exerce une contrainte mécanique de 1 Newton par mètre carré. Lorsque la contrainte est exercée dans le sens de l'épaisseur du film, la densité de charges mesurée correspond au coefficient $d_{33}$. Ce coefficient dépend du mode de polarisation cyclique tel que décrit dans le brevet français 2 538 157. Il est proportionnel à la polarisation rémanente :

$$d_{33} = - Pr \cdot \frac{dv}{V} \cdot \frac{1}{dx_3}$$

et sensiblement égal à $\gamma Pr$

Pr étant la polarisation rémanente

$\frac{dv}{V}$ étant la compressibilité

$dx_3$ étant la contrainte appliquée suivant l'épaisseur

$\gamma$ étant le module de Young

Par ailleurs la température maximum d'utilisation correspond à la température d'utilisation à partir de laquelle le coefficient $d_{33}$ commence à diminuer sensiblement.

De façon générale les copolymères $VF_2$-$C_2F_3H$ sont connus pour leurs propriétés piézoélectriques avec un coefficient piézoélectrique $d_{33}$ élevé, mais ces copolymères toujours de structure homogène possèdent en contrepartie une température maximum d'utilisation relativement basse ou vice versa. Dans le brevet français 2 117 315 sont cités comme piézoélectriques les copolymères de $VF_2$ et de monomère copolymérisable à insaturation éthylénique. Selon ce brevet le copolymère est préparé en suspension avec la mise en présence de la totalité des monomères au moment de l'initiation de la polymérisation. Dans ces conditions on ne peut obtenir qu'un copolymère homogène constitué de chaines de compositions sensiblement identiques. Avec de tels produits il est constaté que, si le comonomère est $C_2F_3H$, quand sa teneur augmente dans le copolymère le coefficient piézoélectrique $d_{33}$ augmente mais la température maximum d'utilisation diminue ; Ceci est lié à la température de Curie qui diminue elle aussi.

Dans le brevet français 2 333 817 sont également décrits des compolymères homogènes obtenus par copolymérisation de $VF_2$ et $C_2F_3H$ présentant le même inconvénient que précédemment. Cet inconvénient est confirmé dans : Polymer Journal Vol. 12 No 4 pp. 209-223 (1980) et Vol. 11 No 6 pp. 429-436 (1979) où il est montré que pour un copolymère homogène $VF_2$ - $C_2F_3H$ le point de Curie diminue au fur et à mesure que le taux de $C_2F_3H$ augmente dans le copolymère.

La présente invention concerne des copolymères $VF_2$ - $C_2F_3H$ possédant à la fois des propriétés piézoélectriques et une température maximum d'utilisation élevée. Cette amélioration s'applique essentiellement à des copolymères hétérogènes. Ces copolymères hétérogènes, par rapport à la moyenne générale de la teneur en maillons comonomères des chaines, possèdent des chaines de compositions différentes les unes des autres, sans commune mesure avec les différences statistiques du copolymère homogène.

Les copolymères hétérogènes sont constitués par un ensemble de chaines macromoléculaires dont la teneur en $C_2F_3H$ varie dans des proportions importantes, les chaines les plus riches en $C_2F_3H$ possédant une teneur molaire sensiblement comprise entre 35 et 44 %, les plus pauvres possédant une teneur sensiblement comprise entre 12,6 et 3 % et celà pour des teneurs molaires globales de $C_2F_3H$ dans le copolymère de moins de 30 %. Par opposition et comparaison un copolymère homogène à teneur molaire globale de $C_2F_3H$ est constitué de chaines macromoléculaires statistiquement sensiblement identiques et contenant toutes sensiblement 30 % de $C_2F_3H$.

Tous les copolymères hétérogènes $VF_2$ - $C_2F_3H$ ne possèdent pas les propriétés précédentes. Seuls sont concernés les copolymères possédant une courbe de répartition de composition molaire cumulée comprise entre deux droites d'équation :

$$Y = -3{,}18\,X + 140$$

et

$$Y = -3{,}12\,X + 109$$

X étant le pourcentage molaire de $C_2F_3H$ dans les chaines macromoléculaires, Y étant le pourcentage pondéral de l'ensemble de chaines macromoléculaires dont la teneur molaire en $C_2F_3H$ est supérieure ou égale à X. Ce pourcentage pondéral est exprimé par rapport au poids total représenté par toutes les chaines quelle que soit leur teneur en $C_2F_3H$.

D'après ces courbes définissant les copolymères $VF_2$ - $C_2F_3H$, ces copolymères sont constitués de l'accumulation de chaines macromoléculaires de $VF_2$ - $C_2F_3H$ dont la teneur molaire en $C_2F_3H$ peut s'étaler dans un intervalle maximum de sensiblement 3 % à sensiblement 44 %. La teneur molaire globale du $C_2F_3H$ dans le copolymère hétérogène est de préférence compris entre 17 et 27 %.

Le pourcentage molaire de $C_2F_3H$ peut être mesuré par résonnance magnétique nucléaire (RMN) du proton, les composantes spectrales des maillons provenant du $VF_2$ et du $C_2F_3H$ étant suffisamment résolues à 200 Mhz pour permettre la mesure de leur intensité relative.

Les pourcentages pondéraux Y et Y′ peuvent être déterminés par une méthode de fractionnement. Une méthode consiste à dissoudre en totalité le copolymère dans un solvant, tel le diméthylformamide, à concentration de 10 g/l. On ajoute ensuite des quantités contrôlées de non solvant, comme le formamide. Cette technique de fractionnement repose sur le principe que les chaines de copolymère les plus riches en $VF_2$ précipitent en premier. Dans le cas de copolymères à répartition moléculaire étalée, il peut se produire simultanément un fractionnement par masses moléculaires, les plus fortes masses précipitant avant les faibles masses. Ce phénomène peut entrainer des irrégularités dans la progression des teneurs en $C_2F_3H$ au cours des fractionnements et entacher d'imprécision la détermination de l'histogramme de composition. Pour remédier à cet inconvénient il convient de s'affranchir du paramètre masse moléculaire en effectuant au préalable un fractionnement par chromatographie d'exclusion stérique (CPC) préparatoire de manière à disposer de six fractionnements suivant les masses moléculaires.

Le fractionnement par GPC préparatoire se fait après avoir mis le copolymère en solution dans un solvant, tel le n-méthyle pyrrolidone. Chacune des six fractions obtenue par GPC est ensuite fractionnée comme suit : après élimination du premier solvant, chacune de ces fractions est dissoute dans un solvant, tel le diméthylformamide, de façon à faire une solution à 10 g/l. On ajoute à 100 $cm^3$ de cette solution une quantité de non solvant, tel le formamide, de manière à faire apparaitre un premier trouble.

Le précipité formé est filtré et séché à l'étuve à 40°C, sous vide, pesé avec soin, puis analysé en RMN du proton. Soit $P_1$ et $X_1$ le poids et la composition $C_2F_3H$ molaire de cette première fraction.

Le filtrat est ensuite additionné d'une nouvelle quantité de non solvant jusqu'à apparition de la précipitation suivante. Ce précipité est filtré et séché, pesé et analysé par RMN du proton. Soit $P_2$ et $X_2$ les poids et composition molaire en $C_2F_3H$ de cette fraction.

On recommence ensuite n fois l'opération précédente jusqu'à ce qu'on ait précipité la totalité du copolymère.

Un poids $P_3$ et une composition $X_3$ pour la 3ème fraction

Un poids $P_4$ et une composition $X_4$ pour la 4ème fraction

Un poids $P_n$ et une composition $X_n$ pour la $n^{ème}$ fraction

Ce fractionnement en composition est effectué sur les six fractions issues de la GPC préparatoire.

La totalité des fractions obtenues sont classées par taux de $C_2F_3H$ décroissant. A chaque fraction classée dans cet ordre est attribué un indice j, j allant de l à m

soit $X_j$ la composition molaire en $C_2F_3H$ de la $j^{ième}$ fraction

soit $P_j$ le poids de la $j^{ième}$ fraction

On construit l'histogramme cumulé de composition en portant Y en fonction de $X_j$

$$Y_j = \frac{\text{poids des j premières fractions}}{\text{poids de la totalité des m fractions}} = \frac{P_1 + P_2 + P_3 .... + P_j}{P_1 + P_2 + P_3 .... + P_m}$$

Pour les copolymères hétérogènes répondant à l'invention les couples $X_j$, $Y_j$ doivent être situés entre deux droites dont les équations ont été données précédemment et illustrées en annexe.

Les copolymères hétérogènes peuvent aussi être caractérisés par spectrométrie infrarouge. Par analogie avec le polyfluorure de vinylidène on dénomme phase alpha, la forme cristalline de structure orthorhombique et de conformation TGTG. La forme cristalline de structure orthorhombique ou pseudohexagonale de conformation zig-zag plan entièrement sous forme trans est appelée phase beta. Par analyse infrarouge on peut mesurer l'absorption à 765 $cm^{-1}$ caractéristique de la phase alpha.

Pour comparer les taux de phase alpha de différents copolymères il faut d'abord s'assurer que tous les échantillons ont subit le même cycle thermique. La méthode de caractérisation préconisée consiste à faire un film d'environ 10 microns d'épaisseur par pressage à 220°C sous 20 tonnes pendant 2 minutes. Le film est disposé entre deux plaques inox de 50 microns d'épaisseur. Le moule est ensuite retiré de la presse et amené rapidement en contact avec la surface d'un moule métallique à la température de 20°C. On définit un rapport R à 765 $cm^{-1}$ de la façon suivante :

$$R = \frac{\text{densité optique à 765 cm}^{-1} \text{ X 100}}{\text{(épaisseur du film) X (\% mole de VF}_2\text{)}}$$

Le rapport R est proportionnel à la quantité de phase alpha.

Par cette méthode est mise en évidence, dans les copolymères homogènes de $VF_2$ et $C_2F_3H$ une chute importante du rapport R à 765 $cm^{-1}$ au delà de 15 % molaire de $C_2F_3H$. Ceci est en accord avec le fait qu'au delà de 15 % molaire de $C_2F_3H$ dans les copolymères homogènes, on perd l'organisation cristalline de type alpha pour avoir une organisation de type beta dont on sait qu'elle est à l'origine des phénomènes piézoélectriques.

Dans les copolymères homogènes de composition $C_2F_3H$ molaire comprise entre 20 et 40 % le rapport R à 765 $cm^{-1}$ est quasiment nul, ce qui est en accord avec l'absence totale de phase alpha qui n'apparait qu'autour de 15 % molaire de $C_2F_3H$. Pour un copolymère $VF_2$-$C_2F_3H$ de composition molaire 90-10, le rapport R à 765 $cm^{-1}$ est voisin de 50 ce qui est en accord avec une part importante de phase alpha.

Pour un copolymère hétérogène selon l'invention ce même rapport varie entre 5 et 50. Ceci est probablement dû à la présence d'une fraction non négligeable de copolymère de composition inférieure à 15 % molaire de $C_2F_3H$ organisé en phase alpha. Cette constation est confirmée par les droites caractéristiques précédentes, et illustrées en annexe, qui montrent que le taux de copolymère de composition inférieure ou égale à 15 % molaire en $C_2F_3H$, et généralement compris entre sensiblement 3 et 15 % molaire en $C_2F_3H$, peut représenter jusqu'à sensiblement 38 % en poids du copolymère total. Il semble que cette présence controlée de phase alpha dans le copolymère, c'est-à-dire aussi de chaines à faible teneur en $C_2F_3H$, permette l'amélioration de la température maximum d'utilisation du copolymère $VF_2$ - $C_2F_3H$, qui malgré tout possède d'excellentes propriétés piézoélectriques grâce à la présence de phase beta apportée par les chaines à forte teneur en $C_2F_3H$.

Un autre avantage des copolymères hétérogènes se révèle dans l'amélioration du coefficient de couplage électromécanique KT. Le coefficient KT reflète l'aptitude d'un matériau piézoélectrique de transformer l'énergie mécanique en énergie électrique ou vice versa. KT est défini par la formule :

$$KT = \left( \frac{e_{33}^2}{C_{33}^D \ \xi_{33}} \right)^{1/2}$$

$e_{33}$ est le coefficient piézoélectrique à une contrainte imposée
$C_{33}^D$ est la constante élastique à induction constante
$\xi_{33}$ est la constante diélectrique qui est également une contrainte imposée

La valeur de KT est obtenue en analysant les fréquences caractéristiques de l'admittance électrique en faisant varier la fréquence de manière à passer la résonnance et l'antirésonnance ainsi que la première harmonique. Le coefficient KT a été évalué à l'aide d'une méthode qui consiste à modéliser la courbe expérimentale selon une technique décrite par OHIGASHI (Journal Applied Physic 47(3) 949-955 (1976)).

L'analyse est faite sur des plaques d'environ 1 $cm^2$ de 140 microns d'épaisseur à des très hautes fréquences de l'ordre de 1-50 Mhz.

Il existe des techniques pour augmenter le coefficient KT, qui consistent en des traitements thermiques bien définis pendant ou avant la polarisation de la plaque. Les brevets européen EP 0207347 et australien B 66933/81 revendiquent de tels procédés. Les valeurs de coefficient KT dont il est fait mention dans la présente invention sont obtenues après des traitements thermiques identiques quel que soit le copolymère.

Les plaques sont trempées et recuites pendant 1 h à 130°C. Les mesures effectuées sur des copolymères homogènes font apparaitre un maximum de coefficient KT pour une composition molaire de 25 % de $C_2F_3H$. Ceci est en accord avec le brevet australien B 66933/81. Ce maximum est de 0,25.

Le copolymère hétérogène de $VF_2$ - $C_2F_3H$ peut être produit par copolymérisation de $VF_2$ et $C_2F_3H$ selon un procédé connu en lui-même.

Dans un mode de préparation préféré on introduit dans un réacteur un mélange de $VF_2$ et $C_2F_3H$ dans des proportions molaires de $VF_2$ comprises entre 67 et 54 % pour 33 et 46 % de $C_2F_3H$. Puis on ajoute progressivement du $VF_2$ en cours de réaction dans des proportions telles que la quantité molaire de $VF_2$ ajoutée représente de 133 à 180 % du nombre de moles de $VF_2$ mis au départ. Le $VF_2$ doit être ajouté progressivement avec un débit d'introduction qui est fonction de la vitesse de polymérisation. Le débit d'introduction de $VF_2$ est de préférence fixé de telle manière que la quantité de $VF_2$ introduite par unité de temps représente de 45 à 65 % en poids du copolymère formé pendant la même unité de temps. Selon ce principe une diminution de la vitesse de réaction au cours de la polymérisation doit être suivie d'une diminution du débit d'introduction de $VF_2$. La réaction de copolymérisation est arrêtée peu après que la totalité du $VF_2$ ait été rajoutée. Les taux de transformation varient entre 65 et 75 %.

La réaction de polymérisation s'effectue en suspension aqueuse dans les conditions habituelles d'agitation, de température et de pression en présence des adjuvants classiques tels que colloïdes protecteurs et initiateurs généralement organosolubles. Selon la méthode de polymérisation en suspension connue on introduit dans le réacteur, contenant l'eau, le colloïde et l'initiateur, le mélange initial de monomères. Sous agitation, on maintient une température comprise entre 30 et 70°C, la pression étant comprise entre 60 et 110 bars.

De façon classique la copolymérisation s'effectue comme ci-dessus dans les conditions où le mélange des monomères est dans l'état hypercritique. Dans ce cas on ajoute régulièrement le $VF_2$ complémentaire de manière à maintenir la pression dans l'autoclave entre la pression choisie P et P-3 bars.

En effet dans l'état hypercritique la consommation de monomère par polymérisation se traduit par une baisse de pression. On limite alors cette baisse de pression à quelques bars en introduisant du $VF_2$ dans l'autoclave, dès que la pression a atteint le seuil bas que l'on ne veut pas dépasser.

Les exemples suivants illustrent l'invention sans toutefois la limiter.

Dans ces exemples, la température maximum d'utilisation est définie en faisant subir à une plaque piézoélectrique polarisée les traitements thermiques suivants :

montée en température de 20°C à T°C à la vitesse de 10°C/min.
palier à T°C pendant une demie-heure
descente en température de T° à 20°C à la vitesse de 10°C/min.

Pendant ces traitements thermiques, l'échantillon est en court circuit pour annuler les tensions élevées induites par effet pyroélectrique. Une mesure du coefficient $d_{33}$ est faite à 20°C après chaque cycle thermique au moyen d'un piézomètre BERLINCOUR. Chaque coefficient $d_{33}$ ainsi mesuré est porté en graphique en fonction de chaque température T correspondante du palier. Par définition la température maximum d'utilisation est la température T du palier pour laquelle le coefficient $d_{33}$ a diminué de 10%.

EXEMPLE 1

Dans un autoclave d'environ 3 l. muni d'un agitateur on introduit 2,17 l. d'eau et 100 cc d'une solution à 1 % de méthylcellulose. Après avoir éliminé l'oxygène sous vide, on ajoute 328 g. de $C_2F_3H$ et 384 g. de $VF_2$, et on monte la température intérieure de l'autoclave à 50°C. Ceci s'accompagne d'une montée en pression jusqu'à 90 bars environ ; on ajoute 2 g. de perdicarbonatediisopropyle dans 40 g. d'acétate d'éthyle pour amorcer la réaction de polymérisation.

On laisse chuter la pression de 90 à 87 bars et on compense la baisse de pression par l'ajout de $VF_2$. Après ajout de 550 g. de $VF_2$ en 5h30 pour compenser les baisses de pression, on la laisse chuter jusqu'à 80 bars et on refroidit brutalement l'autoclave.

Après dégazage du monomère résiduaire le copolymère est lavé et séché. On récupère environ 1070 g. de copolymère.

L'analyse par RMN donne une composition molaire globale de 22 % de $C_2F_3H$.

On réalise ensuite une plaque de 140 microns d'épaisseur par moulage à 200°C. Cette plaque est trempée et recuite 1 h à 130°C.

Des électrodes en platine et or sont déposées sur l'échantillon que est ensuite soumis à une tension sinusoïdale que l'on fait varier progressivement de 30 V/micron à 100 V/micron à une très basse fréquence de 0,01 Hz, en 1 heure conformément au brevet français n° 2 538 157.

Le coefficient $d_{33}$ mesuré sur la plaque traitée est de 31 pc/N (picocoulomb par Newton).

La température maximum d'utilisation est de 110°C.

Le coefficient KT est de 0,3.

Des mesures des divers fractionnements du copolymère il résulte que son histogramme cumulé répond à la formule

$$Y = -3,03 X + 121$$

Le rapport R à 765 $cm^{-1}$ est égal à 17.

EXEMPLE 2 :

Dans un autoclave d'environ 3 l. muni d'un agitateur on introduit 2,17 l. d'eau et 100 cc d'une solution à 1 % de méthylcellulose. Après avoir éliminé l'oxygène sous vide, on ajoute 328 g. de $C_2F_3H$ et 384 g . de $VF_2$, et on monte la température intérieure de l'autoclave à 50°C. Ceci s'accompagne d'une montée en pression jusqu'à 90 bars environ ; on ajoute 2 g. de perdicarbonatediisopropyle dans 40 g. d'acétate d'éthyle pour amorcer la réaction de polymérisation.

On laisse chuter la pression de 90 à 87 bars et on compense la baisse de pression par l'ajout de $VF_2$. Après ajout de 510 g. de $VF_2$ en 5h30 pour compenser les baisses de pression, on la laisse chuter jusqu'à 80 bars et on refroidit brutalement l'autoclave.

Après dégazage du monomère résiduaire le copolymère est lavé et séché. On récupère environ 1014 g. de copolymère.

L'analyse par RMN donne une composition molaire globale de 24 % de $C_2F_3H$.

On réalise ensuite une plaque de 140 microns d'épaisseur par moulage à 200°C. Cette plaque est trempée et recuite 1 h à 130°C.

Des électrodes en platine et or sont déposées sur l'échantillon qui est ensuite soumis à une tension sinusoïdale que l'on fait varier progressivement de 30 V/micron à 100 V/micron à une très basse fréquence de 0,01 Hz, en 1 heure conformément au brevet français n° 2 538 157.

Le coefficient $d_{33}$ mesuré sur la plaque traitée est de 30 pc/N

La température maximum d'utilisation est de 110°C.

Le coefficient KT est de 0,28.

Des mesures des divers fractionnements du copolymère il résulte que son histogramme cumulé répond à la formule

$$Y = -3,75 X + 146$$

Le rapport R à 765 $cm^{-1}$ est égal à 7.

<u>EXEMPLE 3 :</u>

Dans un autoclave d'environ 3 l. muni d'un agitateur on introduit 2,17 l. d'eau et 100 cc d'une solution à 1 % de méthylcellulose. Après avoir éliminé l'oxygène sous vide, on ajoute 328 g. de $C_2F_3H$ et 384 g. de $VF_2$, et on monte la température intérieure de l'autoclave à 50°C. Ceci s'accompagne d'une montée en pression jusqu'à 90 bars environ ; on ajoute 2 g. de perdicarbonatediisopropyle dans 40 g. d'acétate d'éthyle pour amorcer la réaction de polymérisation.

On laisse chuter la pression de 90 à 87 bars et on compense la baisse de pression par l'ajout de $VF_2$. Après ajout de 585 g. de $VF_2$ en 5h30 pour compenser les baisses de pression, on la laisse chuter jusqu'à 80 bars et on refroidit brutalement l'autoclave.

Après dégazage du monomère résiduaire le copolymère est lavé et séché. On récupère environ 1115 g. de copolymère.

L'analyse par RMN donne une composition molaire globale de 19,5 % de $C_2F_3H$.

On réalise ensuite une plaque de 140 microns d'épaisseur par moulage à 200°C. Cette plaque est trempée et recuite 1 h à 130°C.

Des électrodes en platine et or sont déposées sur l'échantillon qui est ensuite soumis à une tension sinusoïdale que l'on fait varier progressivement de 30 V/micron à 100 V/micron à une très basse fréquence de 0,01 Hz, en 1 heure conformément au brevet français n° 2 538 157.

Le coefficient $d_{33}$ mesuré sur la plaque traitée est de 29 pc/N

La température maximum d'utilisation est de 105°C.

Le coefficient KT est de 0,27.

Des mesures des divers fractionnements du copolymère il résulte que son histogramme cumulé répond à la formule

$$Y = -2,84 X + 111,4$$

Le rapport R à 765 $cm^{-1}$ est égal à 26.

<u>EXEMPLE 4 :</u> Exemple comparatif avec un copolymère homogène

Dans un autoclave d'environ 3 l. muni d'un agitateur on introduit 2,17 l. d'eau et 100 cc d'une solution à 1 % de méthylcellulose. Après avoir éliminé l'oxygène sous vide, on ajoute 213 g. de $C_2F_3H$ et 499 g. de $VF_2$ on monte la température à 50°C.

Ceci s'accompagne d'une montée en pression jusqu'à environ 90 bars environ ; on ajoute ensuite 2 g. de perdicarbonate de diisopropyle dans 40 g. d'acétate d'éthyle pour amorcer la polymérisation.

On laisse chuter la pression de 90 à 87 bars et on compense la baisse de pression par l'ajout d'eau. Après avoir ajouté 500 g. d'eau en 5 h. pour maintenir la pression entre 90 et 87 bars on la laisse chuter à 80 bars et on refroidit brutalement l'autoclave.

Après dégazage du monomère résiduaire le copolymère est lavé et séché. On récupère environ 680 g. de copolymère.

L'analyse RMN donne une composition molaire globale de 22 %.

On réalise une plaque de 140 microns d'épaisseur comme décrit dans l'exemple 1 et on la polarise de la même manière.

Les mesures piézoélectriques effectuées sur cette plaque ainsi donnent les résultats suivants :

| | |
|---|---|
| coefficient piézoélectrique $d_{33}$ | : 26 pc/N |
| température maximum d'utilisation | : 102°C |
| coefficient KT | : 0,22 |

Le fractionnement de ce copolymère donne un histogramme cumulé répondant à la formule :

$$X = 23$$

Le comportement au fractionnement est très différent pour les copolymères homogènes. La presque totalité du polymère engagé précipite à la première fraction et les différences extrêmes entre fractions sont toujours inférieures à 5 % molaire de $VF_3$.

Le rapport R à 765 $cm^{-1}$ est nul.

EXEMPLE 5 : comparatif avec un copolymère hétérogène

Dans un autoclave d'environ 3 l. muni d'un agitateur on introduit 2,27 l. d'eau et 100 cc d'une solution à 1 % de méthylcellulose. Après avoir éliminé l'oxygène sous vide, on ajoute 398 g. de $C_2F_3H$ et 314 g. de $VF_2$, et on monte la température à 50°C. Ceci s'accompagne d'une montée en pression jusqu'à 90 bars environ ; on ajoute ensuite 2 g. de perdicarbonate de diisopropyle dans 40 g. d'acétate d'éthyle pour amorcer la réaction de polymérisation. La température de polymérisation est maintenue à 50°C. On laisse chuter la pression de 90 à 87 bars et on compense la baisse de pression par ajout de $VF_2$. Après ajout de 440 g. de $VF_2$ en 4h30 on laisse chuter la pression à 80 bars et on refroidit brutalement l'autoclave. Après dégazage du monomère résiduaire le copolymère est lavé et séché. On récupère environ 880 g. de copolymère.

L'analyse RMN donne une composition molaire globale 29 % en $C_2F_3H$.

On réalise une plaque de 140 microns d'épaisseur et on la polarise de façon identique à l'exemple 1.

Les mesures piézoélectriques effectuées sur la plaque ainsi préparée donnent les résultats suivants :

| | |
|---|---|
| coefficient piézoélectrique $d_{33}$ | : 27 pc/n |
| température maximum d'tilisation | : 76 |
| coefficient de couplage électromécanique | : 0,17 |

Le fractionnement de ce copolymère donne un histogramme cumulé répondant à la formule

$$Y = 3,12 X + 150$$

Le rapport R à 765 $cm^{-1}$ est égal à 0.

EXEMPLE 6 : comparatif avec un copolymère hétérogène.

Dans un autoclave d'environ 3 l. muni d'un agitateur on introduit 2,02 l. d'eau et 100 cc d'une solution à 1 % de méthylcellulose. Après avoir éliminé l'oxygène sous vide, on ajoute 499 g. de $VF_2$ et 213 g. de $C_2F_3H$ et on monte la température à 50°C.

Ceci s'accompagne d'une montée en pression jusqu'à environ 90 bars; on ajoute ensuite 2 g. de perdicarbonate de diisopropyle dans 40 g. d'acétate d'éthyle pour amorcer la réaction de polymérisation. La température de polymérisation est maintenue à 50°C ; on laisse chuter la pression de 90 à 87 bars et on compense la baisse de pression par ajout de $VF_2$. Après ajout de 520 g. de $VF_2$ en 6 h. on laisse chuter la pression à 80 bars et on refroidit brutalement l'autoclave. Après dégazage du monomère résiduaire, le copolymère est lavé et séché. On récupère environ 985 g. de copolymère.

L'analyse RMN donne une composition globale de 17 % molaire de $C_2F_3H$.

On réalise une plaque de 140 microns d'épaisseur et on la polarise de façon strictement identique à l'exemple 1.

Les mesures piézoélectriques effectuées sur la plaque ainsi préparée donnent les résultats suivants :

| | | |
|---|---|---|
| coefficient piézoélectrique $d_{33}$ | : | 20 pc/N |
| température maximum d'utilisation | : | 110°C |
| coefficient KT | : | 15 |

Le fractionnement de ce copolymère donne un histogramme cumulé répondant à la formule :

$$Y = 4,34 X + 117$$

Le rapport R à 765 $cm^{-1}$ est égal à 67.

## Revendications

1. Copolymère de fluorure de vinylidène et de trifluoroéthylène possédant à la fois des propriétés piézoélectriques et une température maximum d'utilisation élevées dont la teneur molaire globale de trifluoroéthylène est inférieure à 30 % caractérisé en ce qu'il possède une structure hétérogène, sa courbe de répartition de composition molaire cumulée étant comprise entre deux droites

$$Y = -3,18 X + 140$$

et

$$Y = -3,12 X + 109$$

X étant le pourcentage molaire de trifluoroéthylène dans les chaînes macromoléculaires et Y étant le pourcentage pondéral de l'ensemble des chaînes macromoléculaires dont la teneur en trifluoroéthylène est supérieure ou égale à X.

2. Copolymère selon la revendication 1 caractérisé en ce qu'il est constitué de l'accumulation de chaînes macromoléculaires de fluorure de vinylidène et de trifluoroéthylène dont la teneur molaire en trifluoroéthylène s'étale dans un intervalle maximum de 3 à 44 %.

3. Copolymère selon l'une des revendcations 1 à 2 caractérisé en ce que le taux de copolymère de composition comprise entre 3 et 15 % molaire de trifluoroéthylène représente jusqu'à 38 % en poids du copolymère total.

4. Copolymère selon l'une des revendications 1 à 3 caractérisé en ce que le rapport $R_x$, déterminé par Infrarouge, défini comme étant

$$\frac{\text{densité optique mesurée à 765 cm}^{-1} \text{ X } 100}{\text{épaisseur d'un film de copolymère X pourcentage de fluorure de vinylidène dans le copolymère}}$$

est compris entre 5 et 50.

5. Procédé de fabrication du copolymère hétérogène des revendications 1 à 4 consistant à copolymériser en suspension aqueuse du fluorure de vinylidène et du trifluoroéthylène en présence de colloïde protecteur et d'initiateur de polymérisation à une température comprise entre 30 et 70°C sous pression comprise entre 60 et 110 bars caractérisé en ce qu'on fait réagir dans un premier temps un mélange de fluorure de vinylidène et de trifluoroéthylène dans des proportions molaires de fluorure de vinylidène comprises entre 67 et 54 % pour 33 à 46 % de trifluoroéthylène et que dans un second temps on ajoute progressivement en cours de réaction du fluorure de vinylidène dans des proportions telles que la quantité molaire de fluorure de vinylidène ajoutée représente de 133 à 180 % du nombre de moles de fluorure de vinylidène initial.

6. Procédé selon la revendication 5 caractérisé en ce que le débit d'introduction du fluorure de vinylidène ajouté est fixé de manière à ce que la quantité de fluorure de vinylidène introduite par unité de temps représente de 45 à 65 % en poids du copolymère formé pendant la même unité de temps.

7. Procédé selon l'une des revendications 5 ou 6 caractérisé en ce qu'on ajoute le fluorure de vinylidène de façon à maintenir la pression dans le milieu réactionnel entre la pression P choisie et P-3 bars.

## Patentansprüche

1. Copolymer aus Vinylidenfluorid und Trifluorethylen, das gleichzeitig erhöhte piezoelektrische Eigenschaften und eine erhöhte maximale Verwendungstemperatur besitzt, dessen molarer Gesamtgehalt an Trifluorethylen geringer ist als 30%, dadurch gekennzeichnet, daß es eine heterogene Struktur hat, wobei seine Kurve der Verteilung der vereinigten, molaren Zusammensetzung zwischen zwei Geraden

$$Y = -3,18 X + 140$$

und

$$Y = -3,12 X + 109 \text{ liegt,}$$

wobei X der molare Prozentsatz des Trifluorethylens in den makromolekularen Ketten ist und Y der Gewichtsprozentsatz der Gesamtheit der makromolekularen Ketten ist, deren Trifluorethylengehalt größer oder gleich X ist.

2. Copolymer nach Anspruch 1, dadurch gekennzeichnet, daß es aus der Anhäufung der Makromolekülketten aus Vinylidenfluorid und Trifluorethylen gebildet ist, deren molarer Gehalt an Trifluorethylen sich auf einen maximalen Bereich von 3 bis 44% verteilt.

3. Copolymer nach Anspruch 1 oder 2, dadurch gekennzeichnet, daß der Gehalt der Copolymeren der Zusammensetzung zwischen 3 und 15 Mol% Trifluorethylen bis zu 38 Gewichtsprozent des gesamten Copolymeren ausmacht.

4. Copolymer nach einem der Ansprüche 1 bis 3, dadurch gekennzeichnet, daß das durch Infrarot bestimmte Verhältnis $R_x$ definiert wird als

$$\frac{\text{Optische Dichte, gemessen bei } 765\ cm^{-1} \times 100}{\text{Dicke eines Copolymerfilms} \times \text{Prozentsatz des Vinylidenfluorids im Copolymer}}$$

und zwischen 5 und 50 liegt.

5. Verfahren zur Herstellung eines heterogenen Copolymers nach den Ansprüchen 1 bis 4, das darin besteht, in wäßriger Suspension Vinylidenfluorid und Trifluorethylen in Gegenwart eines Schutzkolloids und eines Polymerisationsinitiators bei einer Temperatur zwischen 30 und 70°C unter einem Druck zwischen 60 und 100 bar zu copolymerisieren, dadurch gekennzeichnet, daß man in einer ersten Stufe ein Gemisch aus Vinylidenfluorid und Trifluorethylen in Molverhältnissen zwischen 67 und 54% Vinylidenfluorid auf 33 bis 46% Trifluorethylen umsetzt und in einer zweiten Stufe während der Reaktion allmählich Vinylidenfluorid in einem solchen Verhältnis hinzufügt, daß die molare Menge des zugesetzten Vinylidenfluorids 133 bis 180% der Molzahl des ursprünglichen Vinylidenfluorids beträgt.

6. Verfahren nach Anspruch 5, dadurch gekennzeichnet, daß der Durchsatz des zugefügten Vinylidenfluorids so eingestellt ist, daß die pro Zeiteinheit zugesetzte Vinylidenfluoridmenge 45 bis 65 Gewichtsprozent des während der gleichen Zeiteinheit gebildeten Copolymeren beträgt.

7. Verfahren nach einem der Ansprüche 5 oder 6, dadurch gekennzeichnet, daß man das Vinylidenfluorid so hinzufügt, daß der Druck im Reaktionsgemisch zwischen dem gewählten Druck P und P-3 bar aufrechterhalten wird.

## Claims

1. A copolymer of vinylidene fluoride and trifluoroethylene which has both high piezoelectric properties and a high maximum temperature of utilization and whose global molar trifluoroethylene content is lower than 30%, characterized in that it has a heterogeneous structure, its cumulative molar composition distribution curve lying between two straight lines

$$Y = -3.18 X + 140$$

and

$$Y = -3.12 X + 109$$

X being the molar percentage of trifluoroethylene in the macromolecular chains and Y being the percentage by weight of the totality of the macromolecular chains whose trifluoroethylene content is greater than or equal to X.

2. A copolymer according to claim 1, characterized in that it is formed by the accumulation of macromolecular chains of vinylidene fluoride and trifluoroethylene whose molar trifluoroethylene content ranges over a maximum interval of 3 to 44%.

3. A copolymer according to one of claims 1 or 2, characterized in that the amount of copolymer of composition lying between 3 and 15 molar percentage of trifluoroethylene represents up to 38% by weight of the total copolymer.

4. A copolymer according to one of claims 1 to 3, characterized in that the relation $R_X$, determined by infrared, defined as being

$$\frac{\text{optical density measured at } 765\ cm^{-1} \times 100}{\text{thickness of a copolymer film} \times \text{percentage of vinylidene fluoride in the copolymer}}$$

lies betweeen 5 and 50.

5. A process for the preparation of the heterogeneous copolymer according to claims 1 to 4, consisting in copolymerizing vinylidene fluoride and trifluoroethylene in aqueous suspension in the presence of a protective colloid and a polymerization initiator at a temperature between 30 and 70°C and at a pressure between 60 and 110 bar, characterized in that in a first stage a mixture of vinylidene fluoride and trifluoroethylene is reacted in molar proportions of vinylidene fluoride lying between 67 and 54% to 33 to 46% of trifluoroethylene, and in a

second stage vinylidene fluoride is progressively added during the reaction in proportions such that the molar quantity of vinylidene fluoride added represents 133 to 180% of the initial number of moles of vinylidene fluoride.

6. A process according to claim 5, characterized in that the rate of introduction of the added vinylidene fluoride is so fixed that the quantity of vinylidene fluoride introduced per unit of time amounts to 45 to 65% by weight of the copolymer formed during the same unit of time.

7. A process according to one of claim 5 or 6, characterized in that the vinylidene fluoride is so added as to maintain the pressure in the reaction medium between the selected pressure P and a pressure of P-3 bars.

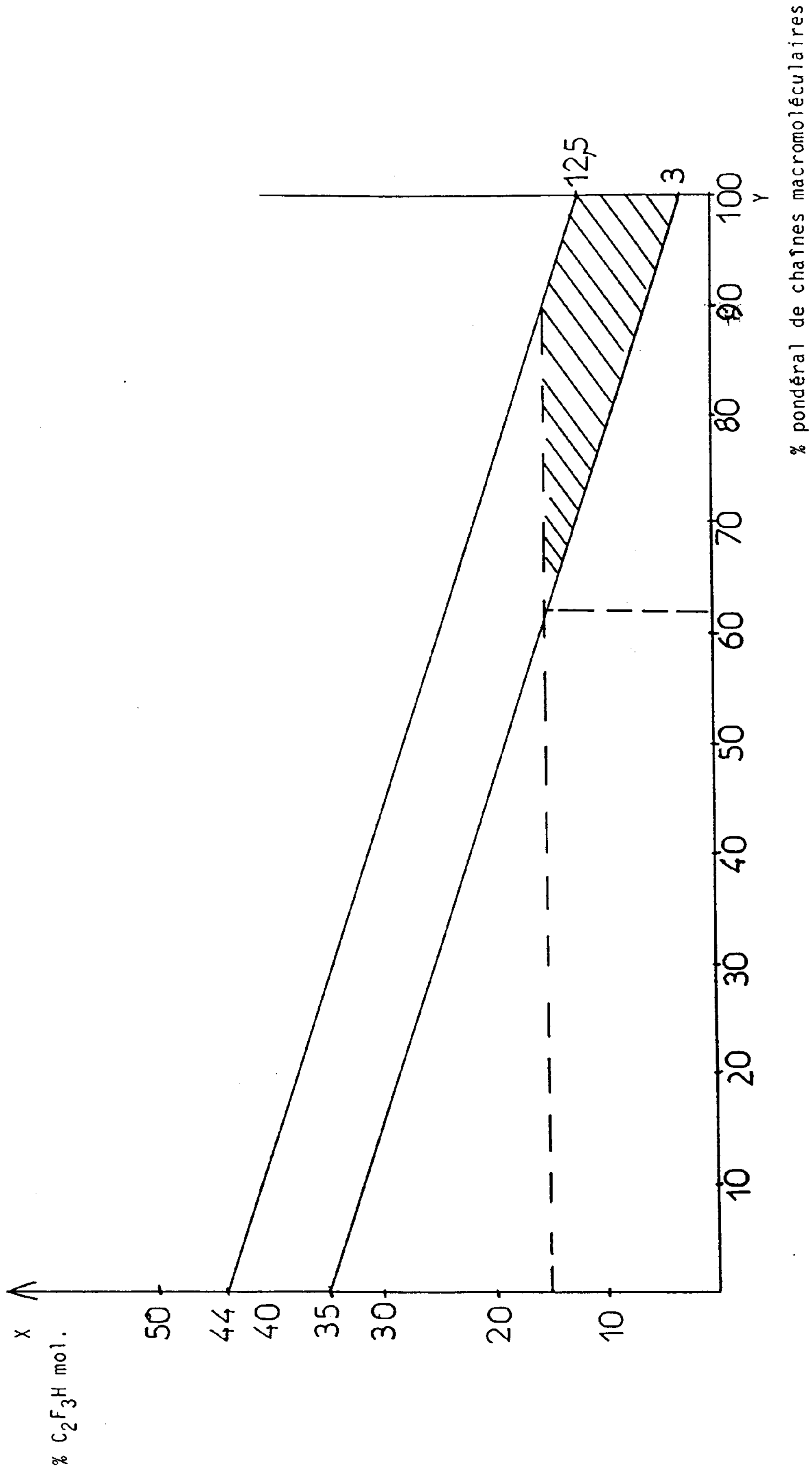
% $C_2F_3H$ mol.
X
50
44
40
35
30
20
10
12,5
3
10
20
30
40
50
60
70
80
90
100
Y
% pondéral de chaînes macromoléculaires